# EUROPEAN PATENT SPECIFICATION

(11) **EP 3 973 749 B1**
(45) Date of publication and mention of the grant of the patent: **25.02.2026**
(21) Application number: 19728933.3
(22) Date of filing: 03.06.2019
(51) Int. Cl.: H05K 7/20, F28F 3/06, H01L 23/367, H01L 23/467

(54) **AN APPARATUS FOR TRANSFERRING HEAT FROM A HEAT SOURCE TO AIR**
VORRICHTUNG ZUR WÄRMEÜBERTRAGUNG VON EINER WÄRMEQUELLE ZU LUFT
APPAREIL POUR TRANSFÉRER DE LA CHALEUR D'UNE SOURCE DE CHALEUR À DE L'AIR

(43) Date of publication of application: 30.03.2022
(73) Proprietor: Huawei Technologies Co., Ltd., Longgang District Shenzhen, Guangdong 518129 (CN)
(72) Inventor: KALLMARK, Magnus, 16440 Kista (SE); OHLSSON, Fredrik, 16440 Kista (SE)
(74) Representative: Maiwald GmbH
(86) International application number: PCT/EP2019/064284
(87) International publication number: WO 2020/244727

(56) References cited:
- EP-A1- 3 270 674
- EP-B1- 3 270 674
- DE-U1- 20 309 856
- GB-A- 2 079 052
- US-A- 5 574 626
- US-A1- 2009 032 234

## Description

### Technical Field

The invention relates to an apparatus for transferring heat from a heat source to air when the apparatus is connected to the heat source, wherein the apparatus comprises a heat sink comprising a heat sink base and a plurality of primary fins attached to the heat sink base. Further, the invention relates to a network access node for a wireless communication system, wherein the network access node comprises an apparatus of the above-mentioned sort. The network access node may comprise a base station.

### Background

Heat sinks are used in various fields of technology, for example in the field of telecommunications, where a heat sink may be installed in a network access node, for example a base station unit or radio unit, to provide cooling. Cooling in a network access node is often needed because of the heat sources or heat generators present in the network access node, for example a transmitter, a printed circuit board, optical transducers, power amplifiers etc. In general, a heat sink has a plurality of primary fins. To these primary fins, secondary fins may be attached to increase the contact area between the heat sink and air, and thus increase the cooling efficiency of the heat sink. However, conventional solutions for attaching the secondary fins to the primary fins are complicated and not that flexible.

DE 203 09 856 U1 describes a cooling sink for semiconductor devices.

### Summary

An object of embodiments of the invention is to provide a solution which mitigates or solves the drawbacks and problems of conventional solutions.

The above and further objects are solved by the subject matter of the independent claim. Further advantageous embodiments of the invention can be found in the dependent claims.

According to a first aspect of the invention, the above mentioned and other objects are achieved with an apparatus for transferring heat from a heat source to air when the apparatus is connected to the heat source. The apparatus comprises a heat sink comprising a heat sink base and a plurality of primary fins attached to the heat sink base. Each primary fin of the plurality of primary fins has a longitudinal extension which extends in a longitudinal direction. Each primary fin has two longitudinal sides and a longitudinal edge located between the two longitudinal sides, each longitudinal side being located between the longitudinal edge and the heat sink base. The longitudinal sides and the longitudinal edge extend in the longitudinal direction. Further, the apparatus comprises one or more members, wherein each member comprises a first wall and a plurality of secondary fins attached to the first wall. Each member is at least partly positioned between two primary fins of the plurality of primary fins. The first wall has a first side in direct physical contact with one of the longitudinal sides of a primary fin of the plurality of primary fins.

The member comprises a second wall to which the secondary fins are attached, wherein the second wall has a first side in direct physical contact with one of the longitudinal sides of a primary fin of the plurality of primary fins. As a result of the direct physical contact between the first side of the second wall and one of the longitudinal sides of a primary fin of the plurality of primary fins, the second wall and the primary fin are thermally coupled to one another in an efficient manner. An advantage with this implementation form is that an efficient thermal coupling between the walls of the member and neighbouring primary fins is provided, whereby the cooling efficiency of the heat sink is further enhanced. Further, the member is easily installed between two primary fins in an uncomplicated manner. Further, no substantial deforming of the member and the primary fins is needed for installing the secondary fins. The solution provided by this implementation form provides an increased flexibility. The number of members added can easily be adjusted, whereby the cooling efficiency of the heat sink can be easily adjusted. The solution provided by this implementation form can speed up the installation of the secondary fins. Alternatively, according to another implementation form of an apparatus according to the first aspect, the secondary fins are attached to one of the longitudinal sides of a primary fin of the plurality of primary fins, i.e. the secondary fins are attached to the primary fin. Advantageously, the secondary fins may be integral with a primary fin of the plurality of primary fins.

The apparatus comprises one or more attachments for attaching the member to a primary fin of the plurality of primary fins.

The attachments comprise a plurality of openings provided in the first and second walls of the member and in the plurality of primary fins, wherein the attachments comprise a rod extending through the plurality of openings, and wherein the attachments are configured to fixate the member in relation to the plurality of primary fins. An advantage with this implementation form is that an uncomplicated and efficient attachment of the member to the primary fins is provided.

An advantage of the apparatus according to the first aspect is that a quick and uncomplicated assembly of the secondary fins is provided. Further, no substantial deforming of the member and the primary fins is required for installing the secondary fins. The solution provided by the apparatus according to the first aspect also provides an increased flexibility, since, for example, the number of secondary fins per member can easily be adjusted and the number of members added can easily be adjusted, whereby the cooling efficiency of the heat sink can be easily adjusted. Further, the solution provided by the apparatus according to the first aspect can speed up the installation of the secondary fins and reduce the labour time for the installation of the secondary fins.

An further advantage of the apparatus according to the first aspect is that the direct physical contact between the first side of the first wall and one of the longitudinal sides of a primary fin of the plurality of primary fins provides an efficient thermal coupling between the first wall of the member and the primary fin. By the direct physical contact between the first side of the first wall and one of the longitudinal sides of the primary fin, instead of a direct physical contact between the member and the longitudinal edge of the primary fin, a larger contact area is provided between the member and the primary fin, and thus also between the secondary fin and the primary fin, which provides an efficient thermal coupling therebetween. By the introduction of the member and its secondary fins, a large contact area between the heat sink and air is provided, which enhances the cooling efficiency of the heat sink. Thus, the heat sink can be reduced in size without reducing the cooling efficiency. Alternatively, the cooling efficiency of the heat sink can be increased without increasing the size of the heat sink. The heat source may be a component of network access node, for example a transmitter. The volume aspect is critical for network access nodes, for example including a base station. Thus, an advantage with the apparatus according to the first aspect of the invention is that the cooling capacity of a network access node, for example a base station unit or radio unit, can be increased as a result of the increase of the contact area between the heat sink and air without increasing the total size of the base station unit or radio unit.

In an implementation form of an apparatus according to the first aspect, the first side of the first wall abuts against one of the longitudinal sides of a primary fin of the plurality of primary fins. An advantage with this implementation form is that an efficient thermal coupling between the first wall of the member and the primary fin is provided.

In an implementation form of an apparatus according to the first aspect, the plurality of secondary fins of the member is integral with the first wall of the member. An advantage with this implementation form is that an efficient thermal coupling between the secondary fins of the member and the first wall of the member is provided, whereby the cooling efficiency of the heat sink is further enhanced.

In an implementation form of an apparatus according to the first aspect, the first wall of the member has a longitudinal extension which extends in the longitudinal direction. An advantage with this implementation form is that a large area of the first side of the first wall can abut against one of the longitudinal sides of the primary fin, whereby an efficient thermal coupling therebetween is provided. Thus, the cooling efficiency of the heat sink is further enhanced.

In an implementation form of an apparatus according to the first aspect, the first side of the second wall abuts against one of the longitudinal sides of a primary fin of the plurality of primary fins. An advantage with this implementation form is that an efficient thermal coupling between the second wall of the member and the primary fin is provided.

In an implementation form of an apparatus according to the first aspect, the plurality of secondary fins of the member is integral with the second wall of the member. An advantage with this implementation form is that an efficient thermal coupling between the secondary fins of the member and the second wall of the member is provided, whereby the cooling efficiency of the heat sink is further enhanced.

In an implementation form of an apparatus according to the first aspect, the second wall of the member has a longitudinal extension which extends in the longitudinal direction. An advantage with this implementation form is that a large area of the first side of the second wall can abut against one of the longitudinal sides of the primary fin, whereby an efficient thermal coupling therebetween is provided. Thus, the cooling efficiency of the heat sink is further enhanced. Alternatively, the longitudinal extension of each of the first and second walls of the member may form an angle with the longitudinal direction, for example may extend transversely to the longitudinal direction.

In an implementation form of an apparatus according to the first aspect, the attachments are configured to attach the member to two primary fins of the plurality of primary fins. An advantage with this implementation form is that an efficient attachment of the member to the primary fins is provided, and an efficient thermal coupling between the member and two neighbouring primary fins can be attained.

In an implementation form of an apparatus according to the first aspect, the rod has a threaded end portion, wherein the attachments comprise a nut, and wherein the nut and the rod are configured to fixate the member in relation to the plurality of primary fins when the threaded end portion of the rod engages the nut. An advantage with this implementation form is that an uncomplicated and efficient attachment of the member to the primary fins is provided.

In an implementation form of an apparatus according to the first aspect, the plurality of secondary fins extends substantially transversely to the first wall. An advantage with this implementation form is that a large contact area between the secondary fins and air is provided.

In an implementation form of an apparatus according to the first aspect, two or more of the members are placed laterally next to one another. An advantage with this implementation form is that a large contact area between the secondary fins and air is provided, whereby the cooling efficiency of the heat sink is further enhanced.

In an implementation form of an apparatus according to the first aspect, two or more of the members are placed after one another in the longitudinal direction. An advantage with this implementation form is that a large contact area between the secondary fins and air is provided, whereby the cooling efficiency of the heat sink is further enhanced.

According to a second aspect of the invention, the above mentioned and other objects are achieved with a network access node for a wireless communication system, wherein the network access node comprises an apparatus according to any one of the appended claims 1 to 15 or according to any of the above- or below-mentioned embodiments or implementation forms of the apparatus. Advantages of the network access node correspond to the advantages of the apparatus and its implementation forms or embodiments mentioned above or below. The network access node may comprise a base station.

Further applications and advantages of embodiments of the invention will be apparent from the following detailed description.

### Brief Description of the Drawings

The appended drawings are intended to clarify and explain different embodiments of the invention, in which:
- Fig. 1: is a schematic perspective view of a heat sink which can be part of an embodiment of the apparatus according to the first aspect;
- Fig. 2: is a schematic perspective view of a member of an embodiment of the apparatus according to the first aspect;
- Fig. 3: is a schematic perspective view of an embodiment of the apparatus according to the first aspect;
- Fig. 4: is a schematic perspective view illustrating a manner to produce the member which can be a part of an embodiment of the apparatus according to the first aspect;
- Fig. 5: schematically illustrates five possible shapes of the secondary fins of the member which can be a part of an embodiment of the apparatus according to the first aspect;
- Fig. 6: schematically illustrates an alternative attachment of the member to a primary fin;
- Fig. 7: schematically illustrates an alternative attachment of the member to a primary fin;
- Fig. 8: schematically illustrates an alternative mounting of members to the primary fins; and
- Fig. 9: schematically illustrates an alternative mounting of the member to a primary fin.

### Detailed Description

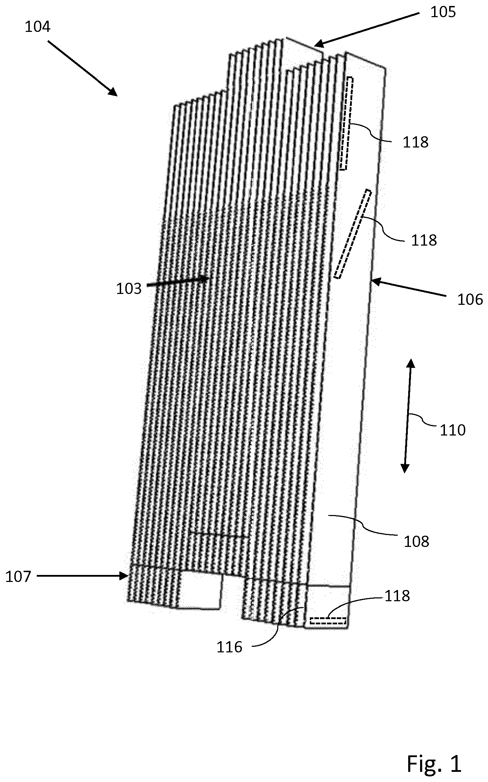

With reference to Fig. 1, a heat sink 104 is schematically illustrated. The heat sink 104 has a heat sink base 106. The heat sink 104 has a plurality of longitudinal primary fins 108 attached to the heat sink base 106. For example, the plurality of primary fins 108 comprises at least ten primary fins 108, for example twenty primary fins 108 or more. However, other numbers are possible. Each primary fin 108 has a longitudinal edge 116 extending in a longitudinal direction 110 and facing the front 103 of the heat sink 104. The heat sink 104 may have a first end 105 and a second end 107. When the heat sink 104 is installed on site, the first end 105 of heat sink 104 may be to the top, and thus a top end, and the second end 107 of the heat sink 104 may be towards ground, and thus a bottom end. However, a different orientation of the installed heat sink 104 is possible. The length of longitudinal extension of the heat sink 104 may be about 700 mm. However, other dimensions are also possible. Each primary fin 108 is made of a thermally highly conductive material. The material of the primary fin 108 may comprise or consist of a metal or a metal alloy, for example aluminum.

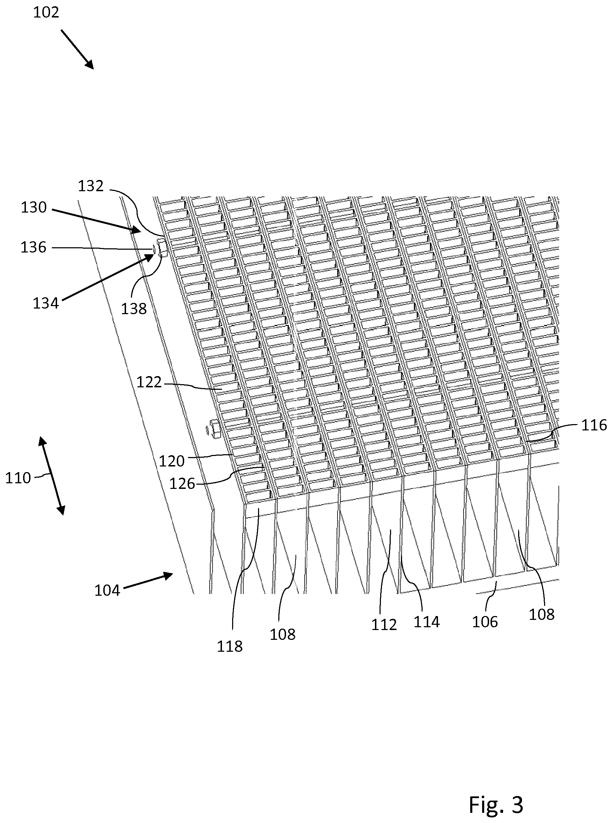

With reference to Fig. 3, an apparatus 102 for transferring heat from a heat source to air when the apparatus 102 is connected to the heat source is schematically illustrated. The heat source may be a component of network access node, for example a transmitter. The apparatus 102 includes a heat sink 104. As in Fig. 1, the heat sink 104 has a heat sink base 106 and a plurality of primary fins 108 attached to the heat sink base 106. Each primary fin 108 of the plurality of primary fins 108 has a longitudinal extension. The longitudinal extension extends in a longitudinal direction 110. The entire primary fin 108 does not have to extend in the same direction, for example in the longitudinal direction 110, but may have one or more portions that are angled in relation to other portions of the same primary fin 108. With reference to Fig. 1, the longitudinal direction 110 can extend from the first end 105 of the heat sink 104 to the second end 107 of the heat sink 104. However, the longitudinal direction could also form an angle with the direction 110 shown in Fig. 1, for example extend transversely to the direction 110 shown in Fig. 1. With reference to Fig. 3, each primary fin 108 has two longitudinal sides 112, 114 and a longitudinal edge 116 located between the two longitudinal sides 112, 114. Each longitudinal side 112, 114 is located between the longitudinal edge 116 and the heat sink base 106. The longitudinal sides 112, 114 and the longitudinal edge 116 extend in the longitudinal direction 110. The width of each longitudinal side 112, 114 of the primary fins 108 exceeds the width of the longitudinal edge 116 by at least ten times, for example by twenty times. However, other dimensions are possible.

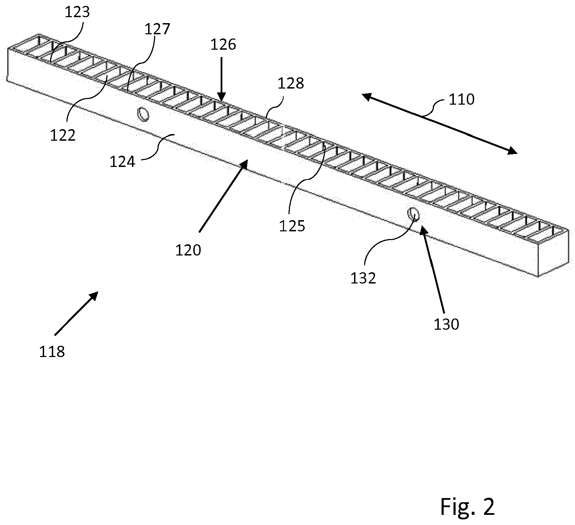

With reference to Figs. 2 and 3, the apparatus 102 includes one or more members 118. Each member 118 is made of a thermally highly conductive material. The material of each member 118 may comprise or consist of a metal or a metal alloy, for example aluminum. However, the material of each member may comprise a graphite or a suitable thermally highly conductive plastic or polymer material, or any other suitable material. Each member 118 has a first wall 120 and a plurality of secondary fins 122 attached to the first wall 120. Each of the primary fins 108 and secondary fins 122 is configured to transfer heat to the ambient air. The plurality of secondary fins 122 may comprise at least ten secondary fins 122, for example twenty secondary fins 122 or more. However, other numbers are possible. Each member 118 also has a second wall 126 to which the secondary fins 122 are attached. In the embodiment shown in Figs. 2 and 3, the plurality of secondary fins 122 of the member 118 is integral with the first wall 120 of the member 118, and the plurality of secondary fins 122 of the member 118 is integral with the second wall 126 of the member 118. In this context, "integral with" means formed in/as one piece, i.e. the member 118 is a one-piece member. The longitudinal length of the member 118 can for example be about 200 mm. However, other dimensions are possible.

In the embodiment shown in Figs. 2 and 3, the plurality of secondary fins 122 extends substantially transversely to the first wall 120 and to the second wall 126. Since the plurality of secondary fins 122 extends substantially transversely to the first and second walls 120, 126, each secondary fin 122 of the plurality of secondary fins 122 extends transversely to the first and second walls 120, 126. Alternatively, the member 118 and secondary fins 122 could be configured such that an acute angle, for example an acute angle of 30° to 60°, is formed between the secondary fin 122 and one of the first and second walls 120, 126. However, other acute angles are possible. Further, the secondary fin 122 may be bent, such that a portion of the secondary fin forms an angle with another portion of the same secondary fin. The first wall 120 of the member 118 may have a longitudinal edge 127 extending in the longitudinal direction 110. In the embodiment of Fig. 2, the secondary fin 122 forms a substantially right angle with the longitudinal edge 127 of the first wall 120. In other embodiments, the secondary fin 122 may form an acute angle with the longitudinal edge 127 of the first wall 120, for example an acute angle of 30° to 60°. However, other acute angles are possible.

The design and the dimension of each member 118 can be tailored and adjusted for a specific application. For example, the angle between the secondary fin 122 and the first and second walls 120, 126 of the member 118 can be adjusted. The angle between the secondary fin 122 and the longitudinal edge 127 of the first wall 120 can be adjusted. The thickness of the walls 120, 126 of the member 118 and the thickness of the secondary fins 122 can be adjusted. The longitudinal length of the member 118 can be adjusted. The space between the secondary fins 122 can be adjusted. Additional dimensions of the member 118 may also be adjusted. By the above-mentioned possibilities of adjustment, a flexible and uncomplicated arrangement of the secondary fins 122 is provided, which offers an easily adjustable cooling efficiency of the heat sink 104.

With reference to Fig. 3, each member 118 is at least partly positioned between two adjacent primary fins 108 of the plurality of primary fins 108. The member 118 is adjacent to the longitudinal edge 116 of the primary fin 108. However, the member 118 may be positioned with a distance to the longitudinal edge 116 of the primary fin 108. The first wall 120 has a first side 124 in direct physical contact with one of the longitudinal sides 112, 114 of a primary fin 108 of the plurality of primary fins 108. More specifically, a surface of the first side 124 of the first wall 120 is in physical contact with a surface of the longitudinal side 112, 114 of a primary fin 108. Thus, the first side 124 of the first wall 120 abuts against a longitudinal side 112, 114 of a primary fin 108 of the plurality of primary fins 108. The first wall 120 and the primary fin 108 are thermally coupled to one another. The second wall 126 has a first side 128 in direct physical contact with one of the longitudinal sides 112, 114 of a primary fin 108 of the plurality of primary fins 108. Thus, the first side 128 of the second wall 126 abuts against one of the longitudinal sides 112, 114 of a primary fin 108 of the plurality of primary fins 108. The second wall 126 and the primary fin 108 are thermally coupled to one another. With reference to Fig. 2, the secondary fins 122 are attached to second sides 123, 125 of the of the first and second walls 120, 126.

With reference to Fig. 3, each of the first and second walls 120, 126 of the member 118 has a longitudinal extension which extends in the longitudinal direction 110. Alternatively, the longitudinal extension of each of the first and second walls 120, 126 of the member 118 may form an angle with the longitudinal direction 110, for example may extend transversely to the longitudinal direction 110. The members 118 mounted to the heat sink 104 may also have different positions or orientations in relation to one another. With reference to Fig. 1, three possible positions or orientations of the member 118 are illustrated. However, other positions or orientations of the members 118 are also possible. With reference to Fig. 3, two or more of the members 118 are placed laterally next to one another. In the embodiment of Fig. 3, several members 118 are placed laterally next to one another. Further, two or more of the members 118 are placed after one another in the longitudinal direction 110. In the embodiment of Fig. 3, several members 118 are placed after one another in the longitudinal direction 110.

With reference to Figs. 2 and 3, the apparatus 102 includes one or more attachments 130 for attaching the member 118 to a primary fin 108 of the plurality of primary fins 108. The attachments 130 may be configured to attach the member 118 to two primary fins 108. The attachments 130 include a plurality of openings 132, for example through-holes, provided in the first and second walls 120, 126 of the member 118 and in the plurality of primary fins 118. The attachments 130 include a rod 134 extending through the plurality of openings 132, wherein the attachments 130 are configured to fixate the member 118 in relation to the plurality of primary fins 108. Advantageously, the rod 134 has a threaded end portion 136. Further, the attachments 130 include a nut 138, and the nut 138 and the rod 134 are configured to fixate the member 118 in relation to the plurality of primary fins 108 when the threaded end portion 136 of the rod 134 engages the nut 138. One and the same rod 134 may be used to attach several members 118 placed laterally next to one another.

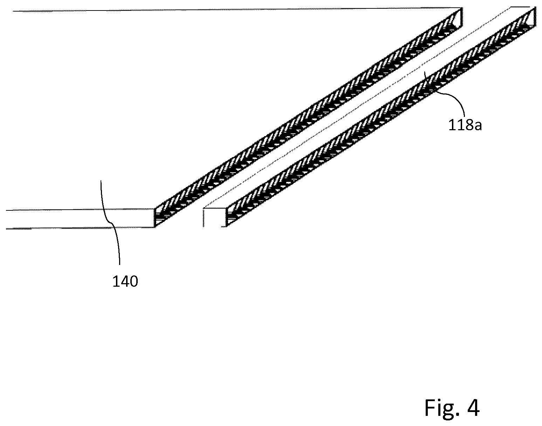

With reference Fig. 4, a method for producing the member 118a is schematically illustrated. The member 118a can be formed by extrusion, and then, each member 118a is cut from the extruded piece 140. In the process, a suitable depth of the member 118a can be chosen when cutting. The cut does not have to be linear, but can instead be curved. It is to be understood that the member 118a may be produced in other ways, for example by way of 3D printing, or casting etc. Alternatively, the secondary fins 122 and the first and second walls 120, 126 may be assembled and attached to one another by soldering or brazing etc.

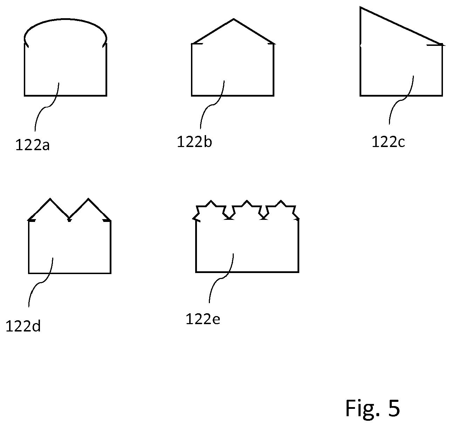

With reference to Fig. 5, five different types of secondary fins 122a-e are schematically illustrated, which can replace the secondary fins 122 shown in Figs. 2 and 3. In Fig. 5, the secondary fins 122a-e of are viewed in the longitudinal direction 110 (see Fig. 2). Especially the secondary fin 122e provides a large contact area between the secondary fin 122e and air. Other shapes of the secondary fin are also possible.

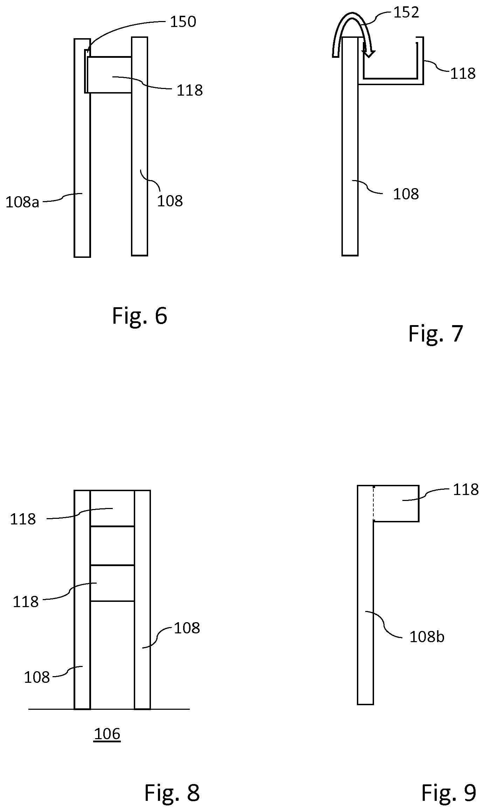

With reference to Figs. 6-9, alternatives for attaching the member 118 to the primary fin 108 or primary fins 108 are schematically illustrated. With reference to Fig. 6, a groove 150 is at least provided in one of two adjacent primary fins 108a, and the member 118 can be pushed or slid into place between two primary fins 108a, 108, or snapped into place. Alternatively, both primary fins 108 in Fig. 6 could be provided with such a groove. With reference to Fig. 7, the member 118 may be attached to the primary fin 108 by means of a clip 152. With reference to Fig. 8, between two adjacent primary fins 108, a member 118 may be located between another member 118 and the heat sink base 106, and the members 118 may be glued to the primary fins 108. With reference to Fig. 8, the member 118 may be integral with one primary fin 108b.

The embodiments of the present invention also comprise a network access node for a wireless communication system, wherein the network access node comprises an apparatus 102 according to any one of the embodiments disclosed above. The network access node may comprise a base station, for example a base radio station. The network access node may include one or more antennas. The base station may have a housing which houses the antenna. Alternatively, the antenna is mounted outside the housing of the base station, for example with a distance to the housing of the base station.

## Claims

1. An apparatus (102) for transferring heat from a heat source to air when the apparatus is connected to the heat source, the apparatus (102) comprising
a heat sink (104) comprising a heat sink base (106) and a plurality of primary fins (108) attached to the heat sink base (106), wherein each primary fin (108) of the plurality of primary fins (108) has a longitudinal extension which extends in a longitudinal direction (110), wherein each primary fin (108) has two longitudinal sides (112, 114) and a longitudinal edge (116) located between the two longitudinal sides (112, 114), wherein each longitudinal side (112, 114) is located between the longitudinal edge (116) and the heat sink base (106), wherein the longitudinal sides (112, 114) and the longitudinal edge (116) extend in the longitudinal direction (110),
wherein the apparatus (102) comprises one or more members (118), wherein each member (118) comprises a first wall (120) and a plurality of secondary fins (122) attached to the first wall (120), wherein each member (118) is at least partly positioned between two primary fins (108) of the plurality of primary fins (108), and
wherein the first wall (120) has a first side (124) in direct physical contact with one of the longitudinal sides (112, 114) of a primary fin (108) of the plurality of primary fins (108);
wherein the attachments (130) are configured to attach the member (118) to two primary fins (108) of the plurality of primary fins (108);
wherein the member (118) comprises a second wall (126) to which the secondary fins (122) are attached, wherein the second wall (126) has a first side (128) in direct physical contact with one of the longitudinal side (112, 114) of a primary fin (108) of the plurality of primary fins (108);
**characterized in that** the attachments (130) comprise a plurality of openings (132) provided in the first and second walls (120, 126) of the member (118) and in the plurality of primary fins (118), wherein the attachments (130) comprise a rod (134) extending through the plurality of openings (132), and wherein the attachments (130) are configured to fixate the member (118) in relation to the plurality of primary fins (108).

2. An apparatus (102) according to claim 1, wherein the first side (124) of the first wall (120) abuts against one of the longitudinal sides (112, 114) of a primary fin (108) of the plurality of primary fins (108).

3. An apparatus (102) according to claim 1 or 2, wherein the plurality of secondary fins (122) of the member (118) is integral with the first wall (120) of the member (118).

4. An apparatus (102) according to any one of the claims 1 to 3, wherein the first wall (120) of the member (118) has a longitudinal extension which extends in the longitudinal direction (110).

5. An apparatus (102) according to any one of the claims 1 to 4, wherein the first side (128) of the second wall (126) abuts against one of the longitudinal sides (112, 114) of a primary fin (108) of the plurality of primary fins (108).

6. An apparatus (102) according to any one of the claims 1 to 5, wherein the plurality of secondary fins (122) of the member (118) is integral with the second wall (126) of the member (118).

7. An apparatus (102) according to any one of the claims 1 to 6, wherein the second wall (126) of the member (118) has a longitudinal extension which extends in the longitudinal direction (110).

8. An apparatus (102) according to any one of the claims 1 to 7, wherein the attachments (130) are configured to attach the member (118) to two primary fins (108) of the plurality of primary fins (108).

9. An apparatus (102) according to any one of the claims 1 to 8, wherein the rod (134) has a threaded end portion (136), wherein the attachments (130) comprise a nut (138), and wherein the nut (138) and the rod (134) are configured to fixate the member (118) in relation to the plurality of primary fins (108) when the threaded end portion (136) of the rod (134) engages the nut (138).

10. An apparatus (102) according to any one of the claims 1 to 9, wherein the plurality of secondary fins (122) extends substantially transversely to the first wall (120).

11. An apparatus (102) according to any one of the claims 1 to 10, wherein two or more of the members (118) are placed laterally next to one another.

12. An apparatus (102) according to any one of the claims 1 to 11, wherein two or more of the members (118) are placed after one another in the longitudinal direction (110).

13. A network access node for a wireless communication system, wherein the network access node comprises an apparatus (102) according to any one of the claims 1 to 12.

## Patentansprüche

1. Vorrichtung (102) zum Übertragen von Wärme von einer Wärmequelle an Luft, wenn die Vorrichtung mit der Wärmequelle verbunden ist, wobei die Vorrichtung (102) umfasst
einen Kühlkörper (104), der eine Kühlkörperbasis (106) und eine Vielzahl von an der Kühlkörperbasis (106) befestigten Primärrippen (108) umfasst, wobei jede Primärrippe (108) der Vielzahl von Primärrippen (108) eine Längserstreckung, die sich in einer Längsrichtung (110) erstreckt, aufweist, wobei jede Primärrippe (108) zwei Längsseiten (112, 114) und eine zwischen den zwei Längsseiten (112, 114) angeordnete Längskante (116) aufweist, wobei sich jede Längsseite (112, 114) zwischen der Längskante (116) und der Kühlkörperbasis (106) befindet, wobei sich die Längsseiten (112, 114) und die Längskante (116) in der Längsrichtung (110) erstrecken,
wobei die Vorrichtung (102) ein oder mehrere Elemente (118) umfasst, wobei jedes Element (118) eine erste Wand (120) und eine Vielzahl von an der ersten Wand (120) befestigten Sekundärrippen (122) umfasst, wobei jedes Element (118) mindestens teilweise zwischen zwei Primärrippen (108) der Vielzahl von Primärrippen (108) positioniert ist, und
wobei die erste Wand (120) eine erste Seite (124) in direktem physischen Kontakt mit einer der Längsseiten (112, 114) einer Primärrippe (108) der Vielzahl von Primärrippen (108) aufweist;
wobei die Befestigungen (130) konfiguriert sind, um das Element (118) an zwei Primärrippen (108) der Vielzahl von Primärrippen (108) zu befestigen;
wobei das Element (118) eine zweite Wand (126), an der die Sekundärrippen (122) befestigt sind, umfasst, wobei die zweite Wand (126) eine erste Seite (128) in direktem physischen Kontakt mit einer der Längsseiten (112, 114) einer Primärrippe (108) der Vielzahl von Primärrippen (108) aufweist;
**dadurch gekennzeichnet, dass**
die Befestigungen (130) eine Vielzahl von Öffnungen (132), die in der ersten und der zweiten Wand (120, 126) des Elements (118) und in der Vielzahl von Primärrippen (118) bereitgestellt sind, umfassen, wobei die Befestigungen (130) eine Stange (134), die sich durch die Vielzahl von Öffnungen (132) erstreckt, umfassen, und wobei die Befestigungen (130) konfiguriert sind, um das Element (118) in Bezug auf die Vielzahl von Primärrippen (108) zu fixieren.

2. Vorrichtung (102) nach Anspruch 1, wobei die erste Seite (124) der ersten Wand (120) an einer der Längsseiten (112, 114) einer Primärrippe (108) der Vielzahl von Primärrippen (108) anliegt.

3. Vorrichtung (102) nach Anspruch 1 oder 2, wobei die Vielzahl der Sekundärrippen (122) des Elements (118) einstückig mit der ersten Wand (120) des Elements (118) ausgebildet ist.

4. Vorrichtung (102) nach einem der Ansprüche 1 bis 3, wobei die erste Wand (120) des Elements (118) eine Längserstreckung, die sich in der Längsrichtung (110) erstreckt, aufweist.

5. Vorrichtung (102) nach einem der Ansprüche 1 bis 4, wobei die erste Seite (128) der zweiten Wand (126) an einer der Längsseiten (112, 114) einer Primärrippe (108) der Vielzahl von Primärrippen (108) anliegt.

6. Vorrichtung (102) nach einem der Ansprüche 1 bis 5, wobei die Vielzahl von Sekundärrippen (122) des Elements (118) einstückig mit der zweiten Wand (126) des Elements (118) ausgebildet ist.

7. Vorrichtung (102) nach einem der Ansprüche 1 bis 6, wobei die zweite Wand (126) des Elements (118) eine Längserstreckung, die sich in der Längsrichtung (110) erstreckt, aufweist.

8. Vorrichtung (102) nach einem der Ansprüche 1 bis 7, wobei die Befestigungen (130) konfiguriert sind, um das Element (118) an zwei Primärrippen (108) der Vielzahl von Primärrippen (108) zu befestigen.

9. Vorrichtung (102) nach einem der Ansprüche 1 bis 8, wobei die Stange (134) einen mit einem Gewinde versehenen Endabschnitt (136) aufweist, wobei die Befestigungen (130) eine Mutter (138) umfassen, und wobei die Mutter (138) und die Stange (134) konfiguriert sind, um das Element (118) in Bezug auf die Vielzahl von Primärrippen (108) zu fixieren, wenn der mit einem Gewinde versehene Endabschnitt (136) der Stange (134) in die Mutter (138) eingreift.

10. Vorrichtung (102) nach einem der Ansprüche 1 bis 9, wobei sich die Vielzahl von Sekundärrippen (122) im Wesentlichen quer zu der ersten Wand (120) erstreckt.

11. Vorrichtung (102) nach einem der Ansprüche 1 bis 10, wobei zwei oder mehr der Elemente (118) seitlich nebeneinander platziert sind.

12. Vorrichtung (102) nach einem der Ansprüche 1 bis 11, wobei zwei oder mehr der Elemente (118) in der Längsrichtung (110) hintereinander platziert sind.

13. Netzwerkzugangsknoten für ein drahtloses Kommunikationssystem, wobei der Netzwerkzugangsknoten eine Vorrichtung (102) nach einem der Ansprüche 1 bis 12 umfasst.

## Revendications

1. Appareil (102) permettant de transférer de la chaleur d'une source de chaleur à l'air lorsque l'appareil est connecté à la source de chaleur, l'appareil (102) comprenant un dissipateur thermique (104) comprenant une base de dissipateur thermique (106) et une pluralité d'ailettes primaires (108) attachées à la base de dissipateur thermique (106), dans lequel chaque ailette primaire (108) de la pluralité d'ailettes primaires (108) a une extension longitudinale qui s'étend dans une direction longitudinale (110), dans lequel chaque ailette primaire (108) a deux côtés longitudinaux (112, 114) et un bord longitudinal (116) situé entre les deux côtés longitudinaux (112, 114), dans lequel chaque côté longitudinal (112, 114) est situé entre le bord longitudinal (116) et la base de dissipateur thermique (106), dans lequel les côtés longitudinaux (112, 114) et le bord longitudinal (116) s'étendent dans la direction longitudinale (110),
dans lequel l'appareil (102) comprend un ou des éléments (118), dans lequel chaque élément (118) comprend une première paroi (120) et une pluralité d'ailettes secondaires (122) attachées à la première paroi (120), dans lequel chaque élément (118) est au moins partiellement positionné entre deux ailettes primaires (108) de la pluralité d'ailettes primaires (108), et
dans lequel la première paroi (120) a un premier côté (124) en contact physique direct avec l'un des côtés longitudinaux (112, 114) d'une ailette primaire (108) de la pluralité d'ailettes primaires (108) ;
dans lequel les attaches (130) sont conçues pour attacher l'élément (118) à deux ailettes primaires (108) de la pluralité d'ailettes primaires (108) ;
dans lequel l'élément (118) comprend une seconde paroi (126) à laquelle les ailettes secondaires (122) sont attachées, dans lequel la seconde paroi (126) a un premier côté (128) en contact physique direct avec l'un des côtés longitudinaux (112, 114) d'une ailette primaire (108) de la pluralité d'ailettes primaires (108) ;
**caractérisé en ce que**
les attaches (130) comprennent une pluralité d'ouvertures (132) prévues dans les première et seconde parois (120, 126) de l'élément (118) et dans la pluralité d'ailettes primaires (118), dans lequel les attaches (130) comprennent une tige (134) s'étendant à travers la pluralité d'ouvertures (132), et dans lequel les attaches (130) sont conçues pour fixer l'élément (118) par rapport à la pluralité d'ailettes primaires (108).

2. Appareil (102) selon la revendication 1, dans lequel le premier côté (124) de la première paroi (120) vient en butée contre l'un des côtés longitudinaux (112, 114) d'une ailette primaire (108) de la pluralité d'ailettes primaires (108).

3. Appareil (102) selon la revendication 1 ou 2, dans lequel la pluralité d'ailettes secondaires (122) de l'élément (118) fait partie intégrante de la première paroi (120) de l'élément (118).

4. Appareil (102) selon l'une quelconque des revendications 1 à 3, dans lequel la première paroi (120) de l'élément (118) a une extension longitudinale qui s'étend dans la direction longitudinale (110).

5. Appareil (102) selon l'une quelconque des revendications 1 à 4, dans lequel le premier côté (128) de la seconde paroi (126) vient en butée contre l'un des côtés longitudinaux (112, 114) d'une ailette primaire (108) de la pluralité d'ailettes primaires (108).

6. Appareil (102) selon l'une quelconque des revendications 1 à 5, dans lequel la pluralité d'ailettes secondaires (122) de l'élément (118) fait partie intégrante de la seconde paroi (126) de l'élément (118).

7. Appareil (102) selon l'une quelconque des revendications 1 à 6, dans lequel la seconde paroi (126) de l'élément (118) a une extension longitudinale qui s'étend dans la direction longitudinale (110).

8. Appareil (102) selon l'une quelconque des revendications 1 à 7, dans lequel les attaches (130) sont conçues pour attacher l'élément (118) à deux ailettes primaires (108) de la pluralité d'ailettes primaires (108).

9. Appareil (102) selon l'une quelconque des revendications 1 à 8, dans lequel la tige (134) a une partie d'extrémité filetée (136), dans lequel les attaches (130) comprennent un écrou (138), et dans lequel l'écrou (138) et la tige (134) sont conçus pour fixer l'élément (118) par rapport à la pluralité d'ailettes primaires (108) lorsque la partie d'extrémité filetée (136) de la tige (134) vient en prise dans l'écrou (138).

10. Appareil (102) selon l'une quelconque des revendications 1 à 9, dans lequel la pluralité d'ailettes secondaires (122) s'étendent sensiblement de manière transversale à la première paroi (120).

11. Appareil (102) selon l'une quelconque des revendications 1 à 10, dans lequel deux des éléments (118) ou plus sont placés de manière latérale, l'un à côté de l'autre.

12. Appareil (102) selon l'une quelconque des revendications 1 à 11, dans lequel deux des éléments (118) ou plus sont placés l'un derrière l'autre dans la direction longitudinale (110).

13. Nœud d'accès au réseau pour un système de communication sans fil, dans lequel le nœud d'accès au réseau comprend un appareil (102) selon l'une quelconque des revendications 1 à 12.
